(19) Europäisches Patentamt
European Patent Office
Office européen des brevets

(11) **EP 0 715 415 B1**

(12) **FASCICULE DE BREVET EUROPEEN**

(45) Date de publication et mention
de la délivrance du brevet:
**10.10.2001 Bulletin 2001/41**

(51) Int Cl.⁷: **H03M 9/00**

(21) Numéro de dépôt: **95410137.4**

(22) Date de dépôt: **27.11.1995**

(54) **Dispositif de sérialisation de données binaires à haut débit**

Vorrichtung zur Parallelserienwandlung von binären Daten mit hoher Datenrate

Device for serialising high data rate binary data

(84) Etats contractants désignés:
**DE FR GB IT**

(30) Priorité: **30.11.1994 FR 9414605**

(43) Date de publication de la demande:
**05.06.1996 Bulletin 1996/23**

(73) Titulaire: **STMicroelectronics S.A.**
**94250 Gentilly (FR)**

(72) Inventeur: **Belot, Didier**
**F-38140 Rives (FR)**

(74) Mandataire: **de Beaumont, Michel**
**1bis, rue Champollion**
**38000 Grenoble (FR)**

(56) Documents cités:
**EP-A- 0 346 896          EP-A- 0 580 234**
**US-A- 3 631 464          US-A- 4 418 418**

## Description

La présente invention concerne un dispositif de sérialisation de données. Elle s'applique plus particulièrement à un multiplexage de données à haut débit, par exemple, au sein d'un circuit de transmission de données en mode asynchrone (ATM).

Dans un tel circuit, les données à transmettre sont constituées de données binaires envoyées en parallèle (par exemple, sur huit bits) vers un dispositif de sérialisation.

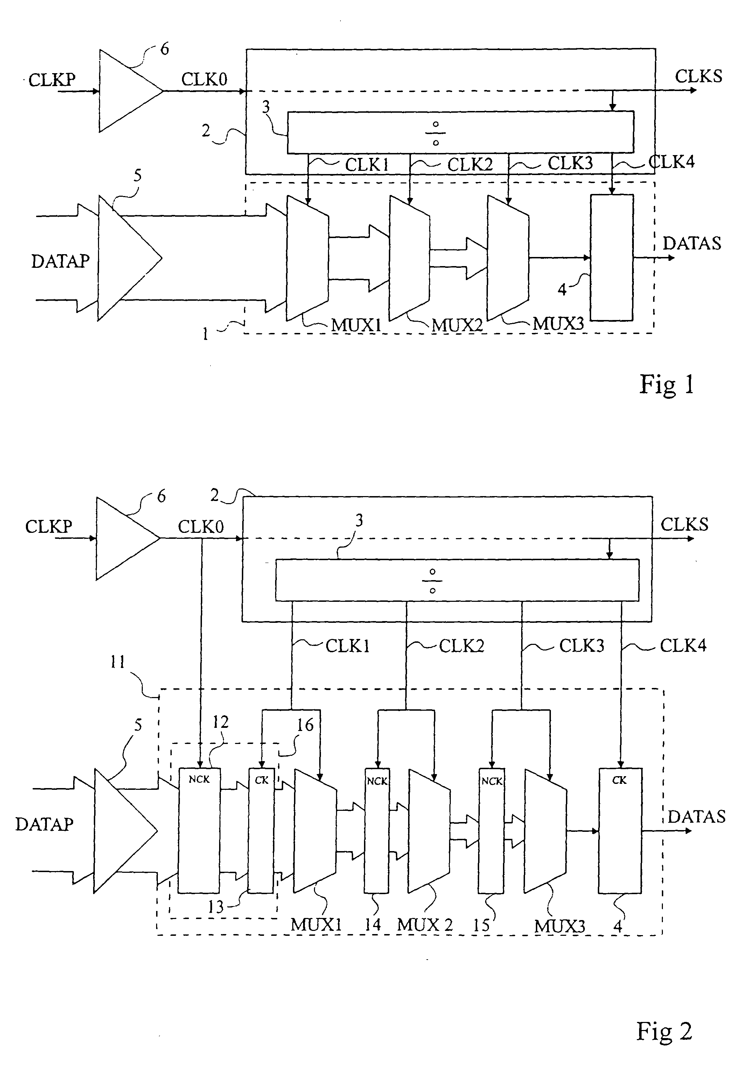

La figure 1 représente un dispositif de sérialisation classique utilisé dans un circuit de transmission de données asynchrone. Ce dispositif 1 est commandé par une boucle à verrouillage de phase (PLL) 2 fournissant un signal d'horloge d'émission des données en série CLKS qui est en phase avec un signal d'horloge CLK0 à une fréquence CLKP d'émission des données en parallèle DATAP. Pour des raisons de clarté, les détails constitutifs de la PLL 2 n'ont pas été représentés. On se bornera à rappeler que la PLL reçoit l'horloge CLK0 et que la phase de cette fréquence d'horloge est comparée à une fréquence reconstituée au moyen d'un diviseur 3 qui reçoit le signal CLKS. Ce signal CLKS provient de l'ajustement d'un oscillateur commandé en tension (VCO) constitué, par exemple, d'un multivibrateur astable commandé à partir du signal de sortie d'un filtre passe-bas. Seul le diviseur 3, ici un diviseur par huit, de la boucle 2 a été représenté à la figure 1.

Le dispositif de sérialisation 1 comporte trois multiplexeurs MUX1, MUX2 et MUX3 et un registre différentiel 4 constitué d'une bascule D. Les multiplexeurs MUX1, MUX2 et MUX3 sont respectivement des multiplexeurs huit vers quatre, quatre vers deux et deux vers un. Le dispositif 1 constitue dans son ensemble un multiplexeur huit vers un. Les signaux d'échantillonnage CLK1, CLK2, CLK3 des multiplexeurs MUX1, MUX2, MUX3 et le signal d'horloge CLK4 du registre 4 proviennent du diviseur 3 de la PLL 2. Les fréquences de ces signaux correspondent respectivement à la fréquence du signal CLKS divisée par huit, par quatre, par deux et par un.

Les données à transmettre DATAP arrivent en parallèle sur un premier convertisseur de niveaux 5 puis sont envoyées sur une entrée de données du dispositif 1. Les données DATAP sont en phase les unes avec les autres. Le convertisseur 5 est destiné à convertir les niveaux logiques des données DATAP issues d'un circuit en technologie CMOS en des niveaux compatibles avec une logique à émetteurs couplés (ECL) constitutive des multiplexeurs et choisie en raison du haut débit de transmission. Les signaux de données issus du convertisseur 5 traversent successivement, sous la commande des signaux CLK1, CLK2, CLK3 et CLK4, les multiplexeurs MUX1, MUX2, MUX3 et le registre 4. La sortie du registre 4 constitue la sortie du dispositif 1 sous la forme d'un signal de données en série DATAS à la fréquence du signal CLKS. Un second convertisseur de niveaux 6 apporte la même conversion sur le signal CLKP avant son entrée dans la PLL 2 que celui apporté par le convertisseur 5 sur les données DATAP.

Dans des applications à haut débit, la fréquence d'arrivée CLKP des données en parallèle DATAP est, par exemple, de 77,76 MHz et la fréquence d'émission CLKS des données sérialisées DATAS est, par exemple, de 622,08 MHz. Ces fréquences sont fixées par la norme ITU 432 pour une application à 155 ou 622 Mbits/s.

Un inconvénient d'un dispositif de sérialisation classique tel que représenté à la figure 1 est lié au temps requis par la boucle à verrouillage de phase 2 pour se caler en phase sur la fréquence CLKP. Ce temps est de l'ordre de 3 à 4 µs alors qu'à la fréquence de 622,08 MHz, la durée d'un bit est d'environ 3,2 ns. Si un tel dispositif fonctionne correctement pour un signal à basse fréquence, son utilisation pour des circuits de transmission à haut débit peut entraîner des pertes d'informations de plus de mille bits de données consécutifs. Ces pertes sont susceptibles de se produire en cas de déverrouillage de la PLL 2 sur la fréquence du signal CLK0 durant la transmission. En effet, si les signaux CLK0 et CLKS ne sont pas parfaitement en phase, les multiplexeurs commandés par les signaux CLK1, CLK2 et CLK3 risquent d'échantillonner deux fois une même donnée ou de ne pas échantillonner une donnée. De telles pertes d'informations conduisent à un taux d'erreur de bits important. En outre, on est contraint dans les circuits classiques d'imposer à chaque mise en route du circuit un délai important de calage de la fréquence d'émission CLKS pendant lequel les données ne peuvent être émises. Un tel délai nuit au débit global du circuit.

Le document EP-A-0 346 896 décrit un convertisseur parallèle-série dans lequel les données à sérialiser sont déphasées d'une valeur prédéterminée π lorsque les phases des signaux d'échantillonnage sont inversées par rapport à la phase du signal d'horloge des données en parallèle. Ce déphasage permet de sérialiser des données qui, lorsqu'elles arrivent en parallèle dans le convertisseur, sont susceptibles d'être déphasées les unes par rapport aux autres. Un tel convertisseur souffre sensiblement des mêmes inconvénients que ceux exposées en relation avec le circuit représenté à la figure 1 dans la mesure où la sélection du déphasage forcé de π des données en parallèle est liée à la boucle à verrouillage de phase entre les horloges d'émission des données sérialisées et d'arrivée des données en parallèle.

La présente invention vise à pallier ces inconvénients en proposant un dispositif de sérialisation de données parallèles à haut débit qui autorise une émission fiable des données même en cas de déphasage de la fréquence d'émission des données en série par rapport à la fréquence d'arrivée des données en parallèle. L'invention vise donc à permettre une sérialisation fiable des données même en cas de déverrouillage de la PLL durant une transmission.

Pour ce faire, l'invention propose de décaler les données à sérialiser d'un temps correspondant au déphasage entre les fréquences d'émission des données sérialisées et d'arrivée des données en parallèle préalablement à leur multiplexage. Si l'on a recours à plusieurs étages de multiplexage, l'invention propose en outre d'effectuer un décalage des données à multiplexer avant chaque étage pour synchroniser les données à multiplexer sur un front du signal d'échantillonnage.

Pour atteindre ces objets, la présente invention prévoit un dispositif de sérialisation de données binaires du type comportant au moins un premier multiplexeur commandé par un premier signal d'échantillonnage délivré par un diviseur d'une boucle à verrouillage de phase d'un signal d'horloge d'émission des données sérialisées sur un premier signal d'horloge de données en parallèle, et qui comporte en amont dudit premier multiplexeur un registre à décalage apportant aux données en parallèle un retard correspondant sensiblement au déphasage éventuel entre ledit premier signal d'horloge et ledit premier signal d'échantillonnage.

Selon un mode de réalisation de l'invention, ledit registre à décalage est constitué d'un premier registre différentiel recevant les données en parallèle et commandé par les fronts descendants dudit premier signal d'horloge suivi d'un second registre différentiel commandé par les fronts montants dudit premier signal d'échantillonnage.

Selon un mode de réalisation de l'invention, le dispositif comporte au moins un deuxième multiplexeur commandé par un deuxième signal d'échantillonnage issu dudit diviseur, la fréquence dudit deuxième signal d'échantillonnage correspondant au double de la fréquence dudit premier signal d'échantillonnage ; ledit deuxième multiplexeur recevant les données délivrées par un troisième registre différentiel commandé par les fronts descendants dudit deuxième signal d'échantillonnage et ledit troisième registre recevant les données issues dudit premier multiplexeur.

Selon un mode de réalisation de l'invention, lesdits registres différentiels sont constitués de bascules D réalisées en logique à émetteurs couplés.

Selon un mode de réalisation de l'invention, le dispositif est intégré à un circuit de transmission en mode asynchrone à haut débit.

L'invention concerne également un circuit de transmission de données en mode asynchrone à haut débit du type comportant un dispositif de sérialisation de données en parallèle pourvu d'au moins trois multiplexeurs commandés par des signaux d'échantillonnage issus d'un diviseur d'une boucle à verrouillage de phase d'un signal d'horloge d'émission des données sérialisées sur un premier signal d'horloge d'arrivée des données en parallèle, chaque multiplexeur étant associé à un registre différentiel commandé par le signal d'échantillonnage du multiplexeur auquel il délivre les données et le registre associé à un premier multiplexeur recevant les données issues d'un premier registre différentiel d'un registre à décalage dont il constitue un second registre, ledit premier registre étant commandé par ledit premier signal d'horloge.

Selon un mode de réalisation de l'invention, lesdits registres différentiels sont respectivement commandés par les fronts descendants dudit premier signal d'horloge, montants d'un premier signal d'échantillonnage du premier multiplexeur, descendants d'un deuxième signal d'échantillonnage d'un deuxième multiplexeur et descendants d'un troisième signal d'échantillonnage d'un troisième multiplexeur.

Selon un mode de réalisation de l'invention, la fréquence dudit premier signal d'horloge est d'environ 77,76 MHz et en ce que la fréquence dudit signal d'horloge d'émission des données sérialisées est d'environ 622,08 MHz.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 décrite précédemment est destinée à exposer l'état de la technique et le problème posé ;
la figure 2 représente un mode de réalisation d'un dispositif de sérialisation selon l'invention ; et
les figures 3 à 7 illustrent sous forme de chronogrammes le fonctionnement du dispositif représenté à la figure 2.

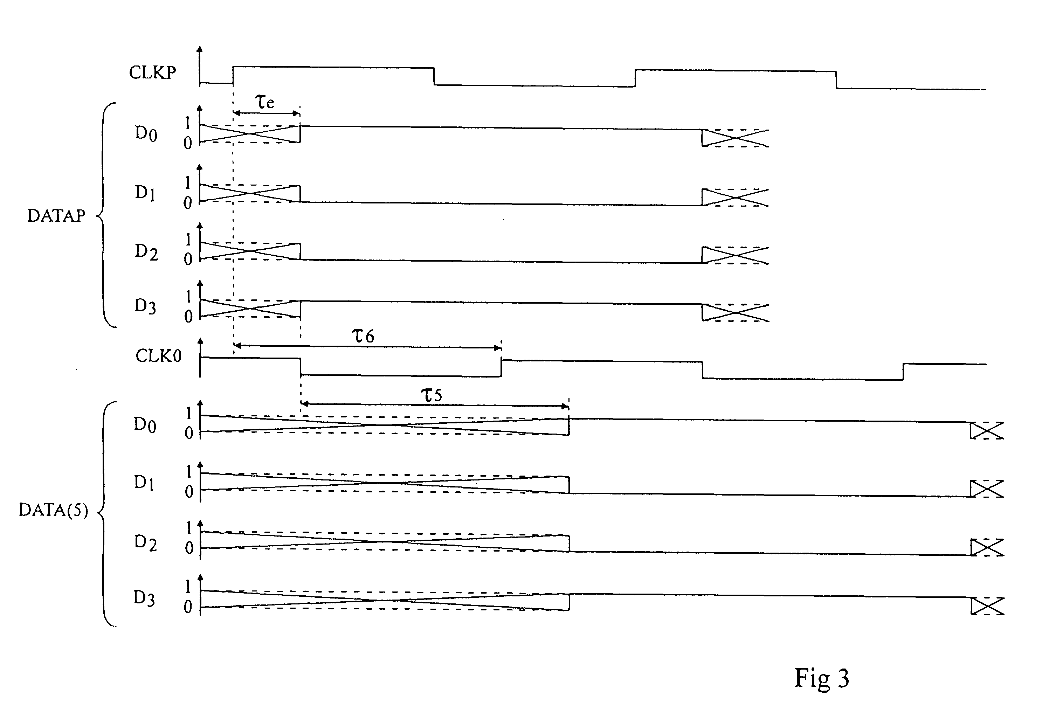

Pour des raisons de clarté, les chronogrammes des figures 3 à 7 ne sont pas à l'échelle. Pour les mêmes raisons, les mêmes éléments ont été désignés par les mêmes références aux différentes figures.

La figure 2 représente un dispositif de sérialisation selon l'invention destiné à multiplexer des mots de données DATAP en parallèle sur huit bits en un signal de données sérialisées DATAS à transmettre. Un tel dispositif est, par exemple, intégré à un circuit de transmission de données en mode asynchrone.

Comme le montre la figure 2, un dispositif de sérialisation 11 selon l'invention comporte cinq registres différentiels 12, 13, 14, 15 et 4 constitués de bascules D et trois multiplexeurs MUX1, MUX2, MUX3. Les signaux DATAP issus d'un premier convertisseur de niveaux 5 traversent successivement les bascules des registres 12 et 13, le multiplexeur MUX1, les bascules du registre 14, le multiplexeur MUX2, les bascules du registre 15, le multiplexeur MUX3 et la bascule du registre 4. Les signaux DATAP sont en phase les uns avec les autres.

Les multiplexeurs MUX1, MUX2 et MUX3 sont comme précédemment respectivement des multiplexeurs huit vers quatre, quatre vers deux et deux vers un. En pratique, tous les multiplexeurs seront, par exemple, constitués d'associations de multiplexeurs deux vers un. Leurs entrées respectives de sélection sont comme précédemment commandées par des signaux d'échantillonnage, respectivement CLK1, CLK2 et CLK3 issus d'un diviseur 3 d'une boucle à verrouillage de phase 2. Le diviseur est, de préférence, un diviseur synchrone, c'est-à-dire que les signaux CLK1, CLK2 et CLK3 sont synchrones. Ces signaux sont par contre en avance par rapport au signal CLK4 ou CLKS d'un temps de propagation dans les bascules D constitutives du premier étage du diviseur.

Les registres 12 et 4 sont, respectivement, commandés par des signaux d'horloge CLK0 et CLK4. Le signal CLK0 correspond au signal d'horloge CLKP d'arrivée des données en parallèles DATAP converti pour être compatible avec une logique à émetteurs couplés (ECL) au moyen d'un second convertisseur de niveaux 6. Le signal CLK0 est envoyé sur les entrées d'horloge inverseuses NCK des bascules du registre 12. En d'autres termes, ces bascules sont commandées par les fronts descendants du signal CLK0. Le signal CLK4 correspond au signal d'horloge CLKS d'émission des données sérialisées et est envoyé sur l'entrée d'horloge non-inverseuse CK de la bascule du registre 4.

Les registres 13, 14 et 15 sont, respectivement, commandés par les signaux CLK1, CLK2 et CLK3. Le signal CLK1 correspond au signal d'horloge CLK4 divisé par huit et est envoyé sur les entrées d'horloge non-inverseuses CK des bascules du registre 13. Le signal CLK2 correspond au signal d'horloge CLK4 divisé par quatre et est envoyé sur les entrées d'horloge inverseuses NCK des bascules du registre 14. Le signal CLK3 correspond au signal d'horloge CLK4 divisé par deux et est envoyé sur les entrées d'horloge inverseuses NCK des bascules du registre 15. En d'autres termes, les registres 14 et 15 sont, respectivement, commandés par les fronts descendants des signaux CLK2 et CLK3, tandis que le registre 13 est commandé par les fronts montants du signal CLK1.

Les registres 12 et 13 constituent ensemble un registre à décalage 16 des signaux de données DATAP avant leur entrée dans le multiplexeur MUX1.

Selon une variante non représentée, tous les signaux de commande des bascules constitutives des registres 12, 13, 14, 15 et 4 sont inversés. En d'autres termes, les registres 12, 14 et 15 sont, respectivement, commandés par les fronts montants des signaux CLK0, CLK2 et CLK3 et les registres 13 et 4 sont, respectivement, commandés par les fronts descendants des signaux CLK1 et CLK4.

Les figures 3 à 7 illustrent le fonctionnement d'un dispositif selon l'invention tel que représenté à la figure 2.

Les figures 3 à 6 illustrent les retards apportés par chaque constituant du dispositif sur des signaux de données DATAP présents sur l'entrée du convertisseur 5 pendant une période du signal CLKP.

Pour des raisons de clarté, on a supposé pour l'établissement des chronogrammes des figures 3 à 6 que les signaux de données DATAP étaient constitués de quatre bits, respectivement D0, D1, D2 et D3. Ainsi, on suppose que le dispositif tel que représenté à la figure 2 est dépourvu du registre 15 et du multiplexeur MUX3 et que le diviseur 3 est un diviseur par quatre. On suppose donc que la sortie du multiplexeur MUX2 est directement envoyée sur la bascule du registre 4 délivrant le signal DATAS, les multiplexeurs MUX1 et MUX2 étant alors, respectivement, des multiplexeurs quatre vers deux (deux multiplexeurs deux vers un) et deux vers un. On suppose en outre que chaque multiplexeur sélectionne sur un front montant de son signal d'échantillonnage la donnée présente sur sa première entrée.

Sur tous les chronogrammes des figures 3 à 6, les différents signaux de données ont été représentés uniquement pendant les périodes utiles à la compréhension de l'invention. Bien entendu, il s'agit de signaux permanents pendant une transmission mais on ne se préoccupe pas de leurs états (symbolisés par des croix) avant et après les périodes utiles à l'exposé.

La figure 3 représente les signaux CLKP, DATAP, CLK0 et DATA(5), où DATA(5) désigne les signaux D0, D1, D2 et D3 en sortie du registre 5.

Les quatre bits D0, D1, D2 et D3 du signal DATAP sont, pour les besoins de l'exposé, positionnés respectivement à 1, 0, 0 et 1 pendant une période d'horloge CLKP représentée à la figure 3.

Les signaux de données DATAP présentent, par rapport au signal CLKP, un retard $\tau e$ dû aux temps de propagation dans les différents composants traversés par ces signaux avant leur arrivée respective sur le convertisseur 6 ou 5. La traversée des convertisseurs 5 et 6, respectivement par les signaux DATAP et CLKP, engendre un retard, respectivement $\tau 5$ et $\tau 6$, des signaux de sorties de ces convertisseurs, respectivement les signaux de données DATA(5) et le signal d'horloge CLK0. Ainsi, les données DATA(5) sont retardées par rapport au signal CLK0 de $\tau 5 + \tau e - \tau 6$. En pratique, les convertisseurs 5 et 6 sont similaires et leurs temps de propagation $\tau 5$ et $\tau 6$ sont identiques.

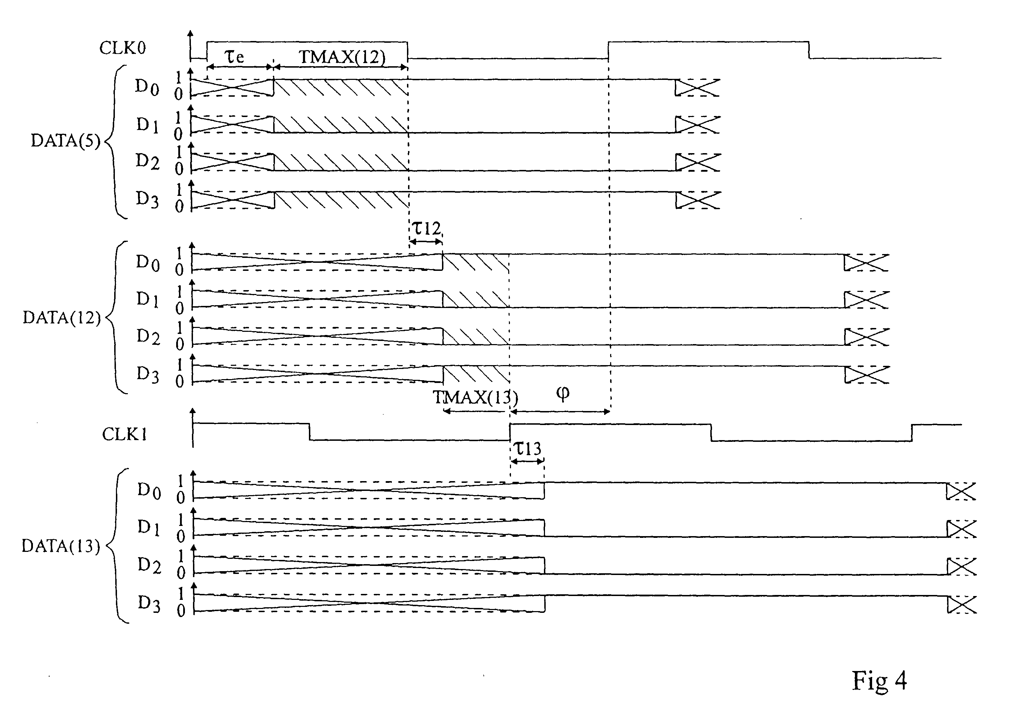

La figure 4 illustre le fonctionnement du registre à décalage 16. Elle représente les signaux CLK0, DATA(5), DATA(12), CLK1 et DATA(13), où DATA(12) et DATA(13) désignent les signaux D0, D1, D2, D3 en sortie des registres, respectivement 12 et 13.

Si $\tau 5 = \tau 6$, les signaux de données DATA(5) arrivent sur le registre à décalage 16 en présentant un retard $\tau e$ par rapport à l'horloge CLK0. Le premier registre 12 du registre à décalage 16 est commandé par les fronts descendants du signal CLK0. Ainsi, les signaux DATA(12) se trouvent retardés, par rapport au signal CLK0, d'une demi-période du signal CLK0 et du temps de propagation $\tau 12$ dans les bascules du registre 12. Les signaux DATA(12) se trouvent donc retardés, par rapport aux signaux DATA(5), d'une demi-période du signal CLK0 et du temps $\tau 12$ diminué du temps $\tau e$.

Ensuite, les signaux DATA(12) traversent le registre 13 qui se trouve commandé par les fronts montants du signal CLK1. Les signaux DATA(13) se trouvent retardés par rapport au signal CLK1 du temps de propagation $\tau13$ dans les bascules du registre 13. Si la PLL 2 n'est pas verrouillée sur la fréquence du signal CLK0, les signaux DATA(13) se trouvent retardés, par rapport aux signaux DATA(12), d'une demi-période du signal CLK0 ainsi que du temps $\tau13$ diminué du temps $\tau12$ et du déphasage $\varphi$ du signal CLK0 par rapport au signal CLK1. Le déphasage $\varphi$ est considéré comme positif si le signal CLK1 est en avance de phase par rapport au signal CLK0 comme cela est représenté à la figure 4.

Les signaux DATA(13) constituent selon l'invention les signaux à sérialiser. Le retard des signaux DATA(13) par rapport aux signaux DATA(5) correspond à une période du signal CLK0 diminuée du déphasage $\varphi$ et des temps $\tau12$ et $\tau13$.

Une caractéristique de l'invention est qu'en cas d'absence de verrouillage de la PLL 2, les signaux de données à sérialiser DATA(13) comprennent l'information du déphasage $\varphi$ entre les signaux CLK0 et CLK1.

En pratique, les bascules D constitutives des registres 12 et 13 sont similaires de sorte que les temps de propagation $\tau12$ et $\tau13$ sont identiques.

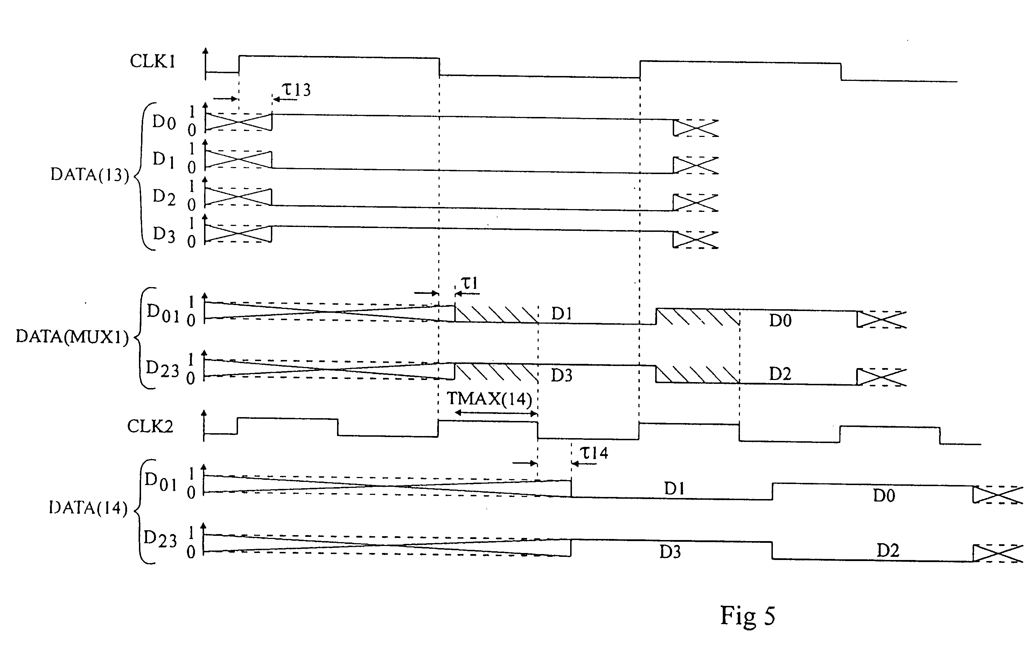

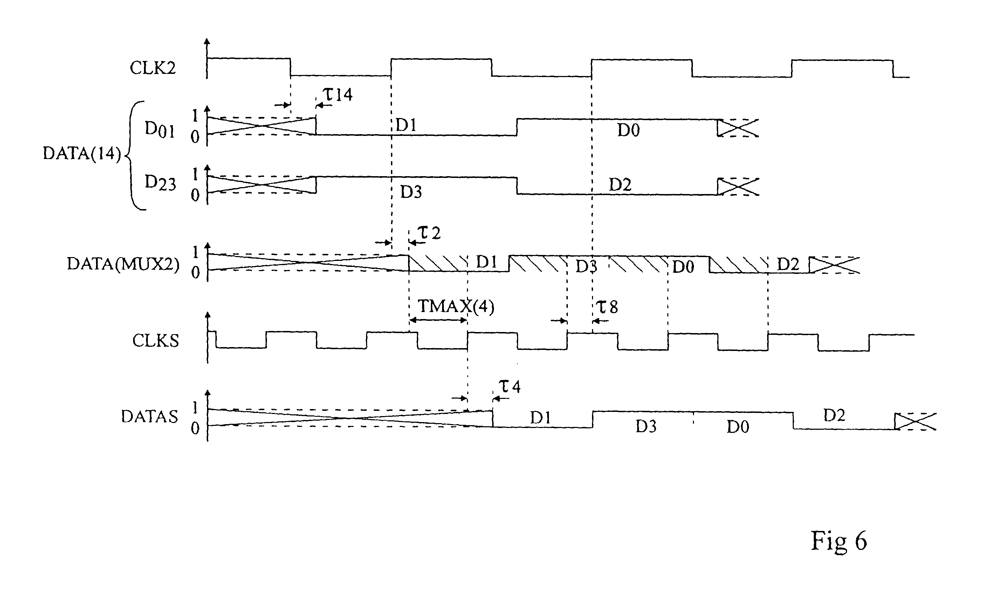

Les figures 5 et 6 illustrent la sérialisation proprement dite des données. La figure 5 représente les signaux CLK1, DATA(13), DATA(MUX1), CLK2 et DATA (14), où DATA(MUX1) et DATA(14) désignent les signaux D01, D23 présents en sortie, respectivement, du multiplexeur MUX1 et du registre 14 et qui représentent le résultat du multiplexage des signaux D0, D1 et D2, D3. La figure 6 représente les signaux CLK2, DATA(14), DATA(MUX2), CLKS et DATAS, où DATA(MUX2) désigne le signal en sortie du multiplexeur MUX2.

Les signaux DATA(MUX1) sont retardés par rapport au signal CLK1 d'un temps $\tau1$ correspondant au temps de propagation dans le multiplexeur MUX1. Selon l'importance du déphasage $\varphi$, le premier front du signal CLK1 après l'apparition des données courantes DATA(13) sur l'entrée du multiplexeur MUX1 est montant ou descendant. Les signaux DATA(MUX1) peuvent donc, le cas échéant, être en plus retardés d'une demi-période du signal CLK1 mais cela est sans incidence sur le fonctionnement du dispositif. En d'autres termes, les premières données des signaux D01 et D23 sont soit D0 et D2, soit D1 et D3 selon l'importance du déphasage $\varphi$.

Les signaux DATA(MUX1) traversent le registre 14 qui se trouve commandé par les fronts descendants du signal CLK2. Ainsi, les signaux DATA(12) se trouvent retardés, par rapport au signal CLK2, d'une demi-période du signal CLK2 et du temps de propagation $\tau14$ dans les bascules du registre 14. Comme le signal CLK1 est synchrone avec le signal CLK2, les signaux DATA(14) se trouvent retardés, par rapport aux signaux DATA(MUX1), d'une demi-période du signal CLK2 et du temps $\tau14$ diminué du temps $\tau1$.

Les signaux D01 et D23 issus du registre 14 sont alors multiplexés (figure 6) sous la commande du signal CLK2. Ainsi, le signal DATA(MUX2) de sortie du multiplexeur MUX2 correspond à la sérialisation des données D1, D3, D0 et D2. Ce signal est retardé par rapport au signal CLK2 d'un temps $\tau2$ apporté par la traversée du multiplexeur MUX2.

Le rôle du registre 14 est de synchroniser les signaux de données sur un front descendant du signal CLK2. Ainsi, à chaque étage de multiplexage, on resynchronise les données sur un front du signal d'échantillonnage et on effectue le multiplexage sur le front suivant.

Le signal DATA(MUX2) traverse enfin le registre 4 qui est commandé par les fronts montants du signal CLK4 à la fréquence du signal CLKS. Ainsi, le signal DATAS se trouve retardé par rapport au signal CLKS, d'une demi-période du signal CLKS et du temps de propagation $\tau4$ dans la bascule du registre 4. De plus, le signal CLKS est en avance par rapport au signal CLK2 du temps de propagation $\tau8$ dans le premier étage de bascules du diviseur 3. Les signaux DATAS se trouvent donc retardés, par rapport aux signaux DATA(MUX2), d'une période du signal CLKS et du temps $\tau4$ diminué des temps $\tau2$ et $\tau8$.

Le raisonnement exposé ci-dessus se transpose à une sérialisation de données en parallèle sur huit bits ou plus.

Un avantage de la présente invention est qu'elle permet une sérialisation sûre des données même en cas de déverrouillage de la PLL 2 pendant la transmission. On diminue ainsi considérablement le taux d'erreur de bit d'un circuit de transmission asynchrone. De plus, on réduit le délai nécessaire à la mise en route du circuit dans la mesure où les fréquences n'ont plus besoin d'être calées avant de commencer à émettre des données. Le circuit selon l'invention permet une émission fiable des données dès que le déphasage entre la fréquence CLK1 et la fréquence CLK0 devient inférieur à environ une demi-période de la fréquence CLKP.

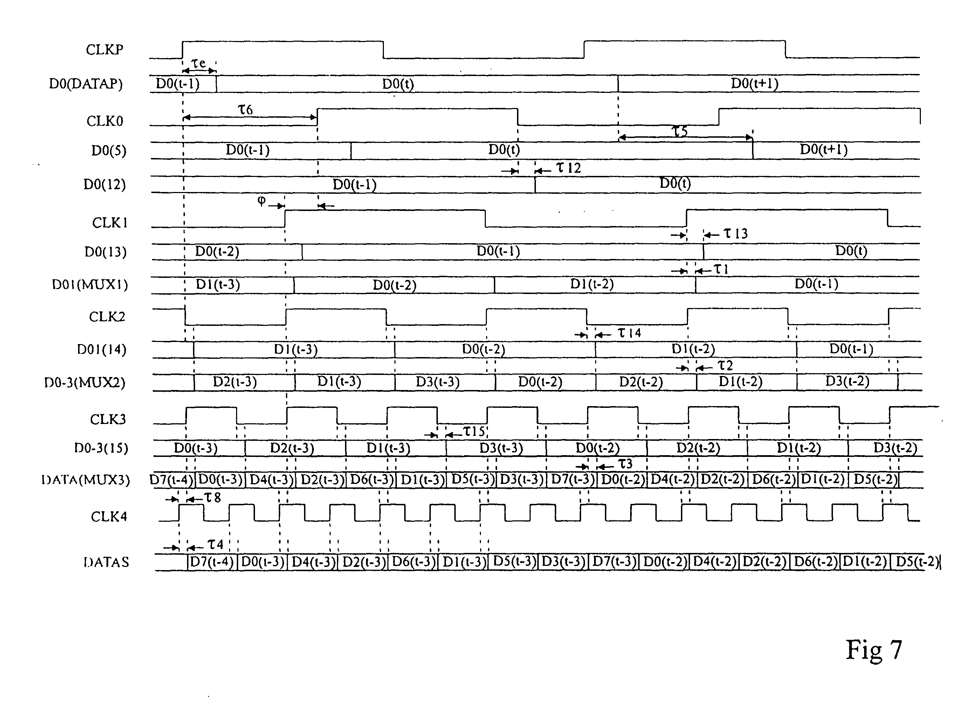

La figure 7 représente les différentes données présentes en sortie des différents éléments du dispositif représenté à la figure 2 pendant une plage temporelle donnée du signal CLKP. Cette figure représente sous forme de chronogrammes les mêmes signaux qu'aux figures 3 à 6 mais pris ici dans une plage temporelle fixe du signal CLKP et complétés pour une sérialisation sur huit bits. Les signaux de données sont représentés sous forme de tronçons dans lesquels les données D0 à D7 ont été affectées d'un indice temporel t représentant la période du signal CLKP dont elles sont issues. Pour des raisons de simplification, un seul signal de données a été représenté (D0, D01, D0-3) lorsque tous les signaux qui lui sont associés (respectivement D1 à D7, D23 à D67, D4-7) sont en phase. Ainsi, seuls les signaux de données D0 des signaux DATAP, DATA(5), DATA(12) et DATA(13) ont été représentés. De même, seuls les signaux D01 des signaux DATA(MUX1) et DATA(14) et seul le signal D0-3 des signaux DATA(15) ont été représ-

sentés. La figure 7 fait apparaître les temps de propagation $\tau 3$ et $\tau 15$, respectivement, dans le multiplexeur MUX3 et dans les bascules du registre 15. Le fonctionnement de ces deux éléments se déduit de celui exposé pour le multiplexeur MUX2 et le registre 14 en relation avec la figure 6.

Pour assurer une synchronisation optimale des différents signaux de données devant être multiplexés, on veillera à ce que les données courantes soient disponibles à l'entrée d'un registre donné avant l'apparition d'un front d'horloge déclencheur, pendant une durée au minimum égale au temps Tset lié aux bascules de ce registre. Ce temps Tset correspond au temps durant lequel une donnée doit être présente avant l'apparition du signal de commande pour être prise en compte par une bascule. On veillera également à ce que, après un front d'horloge déclencheur, les données restent présentes à l'entrée d'un registre donné pendant une durée au minimum égale au temps Thold de prise en compte par les bascules de ce registre.

La traduction de ces contraintes sur les différents retards apportés aux données conduit aux caractéristiques suivantes.

Pour les temps Tset, ces caractéristiques sont exprimées sous la forme du temps Tset maximal que doivent présenter les bascules d'un registre donné en fonction des périodes des différents signaux d'horloge et des temps de propagation dans les différents constituants. Les temps Tset maximum sont représentés aux figures 4 à 6 sous la forme de hachures des signaux de données auxquels ils se rapportent et sont désignés par la référence Tmax suivie de la référence du registre entre parenthèses. Les temps Tmax sont les suivants.

$$Tmax(12) = T(CLK0)/2 - \tau e \; ;$$

$$Tmax(13) = T(CLK1)/2 - \tau 12 - \varphi \; ;$$

et

$$Tmax(14) = T(CLK2)/2 - \tau 1.$$

Dans le cas d'une sérialisation sur quatre bits, on a

$$Tmax\,(4) = T(CLKS) - \tau 2 - \tau 8.$$

Dans le cas d'une sérialisation sur huit bits on a

$$Tmax(15) = T(CLK3)/2 - \tau 2 \; ;$$

et

$$Tmax(4) = T(CLK4) - \tau 3 - \tau 8.$$

Pour les temps Thold, les caractéristiques sont exprimées sous la forme de l'intervalle de temps minimal $\Delta t$ durant lequel une donnée doit rester présente en entrée d'un registre donné avant l'apparition du front déclencheur suivant des bascules de ce registre. En d'autres termes, cet intervalle correspond à l'intervalle minimal entre deux données d'un même signal. Les intervalles $\Delta t$ sont exprimés en fonction des périodes des différents signaux d'horloge, des temps de propagation dans les différents constituants et des temps Thold des bascules des registres auxquels ils se rapportent. Les temps $\Delta t$ sont les suivants.

$$\Delta t(12) = T(CLK0)/2 - Thold(12) \; ;$$

$$\Delta t(13) = T(CLK1)/2 - \varphi - Thold(13) \; ;$$

et

$$\Delta t(14) = T(CLK2)/2 - Thold(14).$$

Dans le cas d'une sérialisation sur quatre bits on a

$$\Delta t(4) = T(CLKS) - \tau 8 - Thold(4).$$

Dans le cas d'une sérialisation sur huit bits on a

$$\Delta t(15) = T(CLK3)/2 - Thold(15) \; ; \text{ et}$$

$$\Delta t(4) = T(CLK4) - \tau 8 - Thold(4).$$

Les temps Thold maximum Thmax des différentes bascules constitutives des registres peuvent se déduire du fait que pour chaque bascule $\Delta t = Tmax + Thmax$. Ainsi, les temps Thmax sont les suivants.

$$Thmax(12) = \tau e/2 \; ;$$

$$Thmax(13) = \tau 12/2 \; ;$$

et

$$Thmax(14) = \tau 1/2.$$

Dans le cas d'une sérialisation sur quatre bits

on a

$$Thmax(4) = \tau2/2.$$

Dans le cas d'une sérialisation sur huit bits on a

$$Thmax(15) = \tau2/2 \ ;$$

et

$$Thmax(4) = \tau3/2.$$

Toutes ces contraintes sur les temps Tset et Thold peuvent être respectées au moyen de bascules et multiplexeurs classiques.

La limite de fonctionnement du dispositif selon l'invention en ce qui concerne le déphasage φ entre les signaux CLK0 et CLK1 se déduit du temps Tset maximal du registre 13. En effet, le temps Tset du registre 13 doit être inférieur à T(CLK0)/2 - τ12 - φ, ce qui entraîne que le déphasage maximal φmax est égal à T(CLK0)/2 - τ12 - Tmax(13).

Ainsi, les données peuvent commencer à être émises après la mise en route du circuit dès que le déphasage φ devient inférieur à T(CLK0)/2 - τ12 - Tmax (13). Par la suite, seules les caractéristiques des bascules constitutives du registre à décalage 16 limitent le déphasage au-delà duquel les données risquent de ne plus être transmises de manière fiable.

Le fait que les données puissent être sérialisées de manière sûre même en cas de déverrouillage de la PLL induit un avantage supplémentaire en matière de consommation d'énergie du circuit de transmission. En effet, alors que dans un circuit classique, la PLL doit fonctionner en permanence pour éviter d'introduire un délai de calage des fréquences avant chaque sérialisation, l'invention permet d'arrêter la PLL hors des périodes où un signal de données en parallèle doit être mis sous la forme de données en série.

En pratique, les multiplexeurs sont, de préférence, tous réalisés à partir de multiplexeurs deux vers un similaires de sorte que les temps de propagation τ1, τ2 et τ3 sont identiques. De même, les bascules D constitutives des registres 14, 15 et 4 et du premier étage du diviseur 3 sont, de préférence, similaires de sorte que les temps de propagation τ14, τ15, τ4 et τ8 sont identiques.

A titre d'exemple de réalisation pour un circuit de transmission de données en mode asynchrone à 622,08 MHz, des convertisseurs, bascules et multiplexeurs existants possédant les caractéristiques suivantes peuvent être utilisés.

Les convertisseurs 5 et 6 sont constitués de convertisseurs de niveau CMOS vers un niveau ECL dont le temps de propagation τ maximal est d'environ 4,5 ns.

Les bascules des registres 12 et 13 sont constituées de bascules D à 155 MHz dont le temps de propagation τ maximal est d'environ 400 ps, dont le temps Tset maximal est d'environ 30 ps et dont le temps Thold est inférieur à 1 ps.

Les bascules du diviseur 3 et des registres 14, 15 et 4 sont constituées de bascules D à 622 MHz dont le temps de propagation τ maximal est d'environ 300 ps, dont le temps Tset maximal est d'environ 50 ps et dont le temps Thold est inférieur à 1 ps.

Les multiplexeurs MUX1, MUX2 et MUX3 sont constitués de multiplexeurs deux vers un dont le temps de propagation τ maximal est d'environ 250 ps.

Avec de tels composants, le déphasage maximal φmax que peut supporter le dispositif entre les signaux CLK0 et CLK1 sans nuire à la sérialisation des données même en cas de déverrouillage de la PLL 2 est d'environ 6,00 ns alors que la période du signal CLK0 est de l'ordre de 12,86 ns. Ainsi, même pour un déphasage de plus ou moins environ 168° le dispositif selon l'invention permet de sérialiser les données de manière sûre.

Bien entendu, la présente invention est susceptible de diverses variantes et modifications qui apparaîtront à l'homme de l'art. En particulier, chacun des composants décrits pourra être remplacé par un ou plusieurs éléments remplissant la même fonction. De plus, bien que la présente description ait été faite en relation avec une sérialisation de données en parallèle sur huit bits, l'invention s'applique quel que soit le nombre de bits en parallèle constituant un mot de données à sérialiser.

## Revendications

1. Dispositif (11) de sérialisation de données binaires du type comportant au moins un premier multiplexeur (MUX1) commandé par un premier signal d'échantillonnage (CLK1) délivré par un diviseur (3) d'une boucle à verrouillage de phase (2) d'un signal d'horloge d'émission (CLKS) des données sérialisées (DATAS) sur un premier signal d'horloge (CLK0) de données en parallèle (DATAP), **caractérisé en ce qu'**il comporte en amont dudit premier multiplexeur (MUX1) un registre à décalage (16) apportant aux données en parallèle (DATAP) un retard correspondant sensiblement au déphasage éventuel (φ) entre ledit premier signal d'horloge (CLK0) et ledit premier signal d'échantillonnage (CLK1).

2. Dispositif de sérialisation de données binaires selon la revendication 1, **caractérisé en ce que** ledit registre à décalage (16) est constitué d'un premier registre différentiel (12) recevant les données en parallèle (DATAP) et commandé par les fronts descendants dudit premier signal d'horloge (CLK0) suivi d'un second registre différentiel (13) commandé par les fronts montants dudit premier signal d'échantillonnage (CLK1).

3. Dispositif de sérialisation de données binaires selon la revendication 1 ou 2, **caractérisé en ce qu'**il comporte au moins un deuxième multiplexeur (MUX2) commandé par un deuxième signal d'échantillonnage (CLK2) issu dudit diviseur (3), la fréquence dudit deuxième signal d'échantillonnage (CLK2) correspondant au double de la fréquence dudit premier signal d'échantillonnage (CLK1) ; et **en ce que** ledit deuxième multiplexeur (MUX2) reçoit les données (DATA(14)) délivrées par un troisième registre différentiel (14) commandé par les fronts descendants dudit deuxième signal d'échantillonnage (CLK2), ledit troisième registre (14) recevant les données (DATA(MUX1)) issues dudit premier multiplexeur (MUX1).

4. Dispositif de sérialisation de données binaires selon la revendication 2 ou 3, **caractérisé en ce que** lesdits registres différentiels (12, 13, 14) sont constitués de bascules D réalisées en logique à émetteurs couplés.

5. Dispositif de sérialisation de données binaires selon l'une quelconque des revendications 1 à 4, **caractérisé en ce qu'**il est intégré à un circuit de transmission en mode asynchrone à haut débit.

6. Circuit de transmission de données en mode asynchrone (ATM) à haut débit du type comportant un dispositif (11) de sérialisation de données en parallèle (DATAP) pourvu d'au moins trois multiplexeurs (MUX1, MUX2, MUX3) commandés par des signaux d'échantillonnage (CLK1, CLK2, CLK3) issus d'un diviseur (3) d'une boucle à verrouillage de phase (2) d'un signal d'horloge (CLKS) d'émission des données sérialisées (DATAS) sur un premier signal d'horloge (CLK0) d'arrivée des données en parallèle (DATAP), **caractérisé en ce que** chaque multiplexeur est associé à un registre différentiel (13, 14, 15) commandé par le signal d'échantillonnage (CLK1, CLK2, CLK3) du multiplexeur auquel il délivre les données ; et **en ce que** le registre (13) associé à un premier multiplexeur (MUX1) reçoit les données (DATA(12)) issues d'un premier registre différentiel (12) d'un registre à décalage (16) dont il constitue un second registre, ledit premier registre (12) étant commandé par ledit premier signal d'horloge (CLK0).

7. Circuit de transmission de données en mode asynchrone (ATM) à haut débit selon la revendication 6, **caractérisé en ce que** lesdits registres différentiels (12, 13, 14, 15) sont respectivement commandés par les fronts descendants dudit premier signal d'horloge (CLK0), montants d'un premier signal d'échantillonnage (CLK1) du premier multiplexeur (MUX1), descendants d'un deuxième signal d'échantillonnage (CLK2) d'un deuxième multiplexeur (MUX2) et descendants d'un troisième signal d'échantillonnage (CLK3) d'un troisième multiplexeur (MUX3).

8. Circuit de transmission de données en mode asynchrone (ATM) à haut débit selon la revendication 6 ou 7, **caractérisé en ce que** la fréquence dudit premier signal d'horloge (CLK0) est d'environ 77,76 MHz et **en ce que** la fréquence dudit signal d'horloge (CLKS) d'émission des données sérialisées (DATAS) est d'environ 622,08 MHz.

**Patentansprüche**

1. Vorrichtung (11) zur Serialisierung binärer Daten, vom Typ mit wenigstens einem ersten Multiplexer (MUX1), der durch ein erstes Sampling-Signal (CLK1) gesteuert wird, das von einem Teiler (3) einer Phasenverriegelungsschleife (2) aus einem Taktsignal (CLKS) zur Emission bzw. Übertragung der serialisierten Daten (DATAS) auf einem ersten Taktsignal (CLK0) von parallelen Daten (DATAP) geliefert wird, **dadurch gekennzeichnet, daß** die Vorrichtung stromaufwärts des genannten ersten Multiplexers (MUX1) ein Schieberegister (16) aufweist, welches den Paralleldaten (DATAP) eine Verzögerung erteilt, die im wesentlichen der eventuellen Phasenversetzung ($\varphi$) zwischen dem genannten ersten Taktsignal (CLK0) und dem genannten ersten Sampling-Signal (CLK1) entspricht.

2. Vorrichtung zur Serialisierung binärer Daten, nach Anspruch 1, **dadurch gekennzeichnet, daß** das genannte Schieberegister (16) von einem ersten Differenzregister (12) gebildet wird, welches die Paralleldaten empfängt und durch die abfallenden Flanken des genannten ersten Taktsignals (CLK0) gesteuert wird, gefolgt von einem zweiten Differenzregister (13), das durch die ansteigenden Flanken des genannten ersten Samplingsignals (CLK1) gesteuert wird.

3. Vorrichtung zur Serialisierung binärer Daten, nach Anspruch 1 oder 2, **dadurch gekennzeichnet, daß** die Vorrichtung wenigstens einen zweiten Multiplexer (MUX2) aufweist, der durch ein von dem genannten Teiler (3) ausgehendes zweites Sampling-Signal (CLK2) gesteuert wird, wobei die Frequenz des genennten zweiten Samplingsignals (CLK2) dem Doppelten der Frequenz des genannten ersten Samplingsignals (CLK1) entspricht; und daß der genannte zweite Multiplexer (MUX2) die Daten (DATA(14)) empfängt, die von einem durch die abfallenden Flanken des genannten zweiten Samplingsignals (CLK2) gesteuerten dritten Differenz-Register (14) geliefert werden, wobei das genannte dritte Register (14) die von dem genannten ersten Multiplexer (MUX1) kommenden Daten (DATA (MUX1)) empfängt.

4. Vorrichtung zur Serialisierung binärer Daten, nach Anspruch 2 oder 3, **dadurch gekennzeichnet, daß** die genannten Differenzregister (12, 13, 14) von in ECL-Technik ausgebildeten D-Kippschaltungen gebildet werden.

5. Vorrichtung zur Serialisierung binärer Daten, nach einem der Ansprüche 1 bis 4, **dadurch gekennzeichnet, daß** sie in eine in Asynchron-Mode betriebene Übertragungsschaltung mit hoher Datenflußrate integriert ist.

6. Vorrichtung zur Datenübertragung in Asynchron-Mode (ATM) mit hoher Datenflußrate, welche eine Vorrichtung (11) zur Serialisierung von Paralleldaten (DATAP) aufweist, die mit wenigstens drei Multiplexern (MUX1, MUX2, MUX3) versehen ist, welche durch Samplingsignale (CLK1, CLK2, CLK3) gesteuert werden, die von einem Teiler (3) einer Phasenverriegelungsschleife (2) eines Taktsignals (CLKS) für die Aussendung bzw. Übertragung serialisierter Daten (DATAS) ausgehen, die gemäß einem ersten Taktsignal (CLK0) für das Eintreffen der ParallelDaten (DATAP) serialisiert sind, **dadurch gekennzeichnet, daß** jeweils jeder Multiplexer einem Differenzregister (13, 14, 15) zugeordnet ist, das durch das Samplingsignal (CLK1, CLK2, CLK3) des Multiplexers, dem es die Daten zuführt, gesteuert wird; und daß das einem ersten Multiplexer (MUX1) zugeordnete Differenzregister (13) die Daten (DATA12) erhält, die von einem ersten Differenzregister (12) eines Schieberegisters (16) kommen, von welchem es ein zweites Register bildet, wobei das genannte erste Register (12) durch das genannte erste Taktsignal (CLK0) gesteuert wird.

7. Asynchron-Mode (ATM)-Datenübertragungsschaltung mit hoher Datenflußrate, nach Anspruch 6, **dadurch gekennzeichnet, daß** die genannten Differenzregister (12, 13, 14, 15) jeweils entsprechend gesteuert werden durch die abfallenden Flanken des genannten ersten Taktsignals (CLK0), durch die ansteigenden Flanken eines ersten Samplingsignals (CLK1) des ersten Multiplexers (MUX1), durch die abfallenden Flanken eines zweiten Samplingsignals (CLK2) eines zweiten Multiplexers (MUX2), bzw. durch die abfallenden Flanken eines dritten Samplingsignals (CLK3) eines dritten Multiplexers (MUX3).

8. Asynchron-Mode (ATM)-Datenübertragungsschaltung mit hoher Datenflußrate, nach Anspruch 5 oder 7, **dadurch gekennzeichnet, daß** die Frequenz des genannten ersten Taktsignals (CLK0) ungefähr 77,76 MHz beträgt, und daß die Frequenz des genannten Taktsignals (CLKS) für die Aussendung bzw. Übertragung der serialisierten Daten (DATAS) ungefähr 622,08 MHz beträgt.

**Claims**

1. A device (11) for serializing binary data including at least one first multiplexer (MUX1) controlled by a first sampling signal (CLK1) provided by a divider (3) of a phase-locked loop (2) of a transmission clock signal (CLKS) of serialized data (DATAS) on a first clock signal (CLK0) of parallel data (DATAP), **characterized in that** it comprises, upstream said first multiplexer (MUX1), a shift register (16) for conferring to the parallel data (DATAP) a delay substantially corresponding to the possible phase-shift ($\varphi$) between said first clock signal (CLK0) and said first sampling signal (CLK1).

2. The serialization device of claim 1, **characterized in that** said shift register (16) is constituted by a first differential register (12), that receives parallel data (DATAP) and is controlled by the falling edges of said first clock signal (CLK0) , followed by a second differential register (13) controlled by the rising edges of said first sampling signal (CLK1).

3. The serialization device of claim 1 or 2, **characterized in that** it includes at least a second multiplexer (MUX2) controlled by a second sampling signal (CLK2) provided by said divider (3), the frequency of said second sampling signal (CLK2) being twice the frequency of said first sampling signal (CLK1); and said second multiplexer (MUX2) receives data (DATA(14)) provided by a third differential register (14) controlled by the falling edges of said second sampling signal (CLK2), said third register (14) receiving the data (DATA(MUX1)) provided by said first multiplexer (MUX1).

4. The serialization device of claim 2 or 3, **characterized in that** said differential registers (12, 13, 14) are constituted by ECL D-type flip-flops.

5. The serialization device of any of claims 1 to 4, **characterized in that** it is included in a high flow asynchronous transmission circuit.

6. A high-flow asynchronous transmission mode (ATM) circuit, including a device (11) for serializing parallel data (DATAP) having at least three multiplexers (MUX1, MUX2, MUX3) controlled by sampling signals (CLK1, CLK2, CLK3) originating from a divider (3) of a phase-locked loop (2) of a clock signal (CLKS) transmitting data (DATAS) serialized in correspondence with a first clock signal (CLK0) indicating the arrival of parallel data (DATAP), **characterized in that** each multiplexer is associated with a differential register (13, 14, 15) controlled by the sampling signal (CLK1, CLK2, CLK3) of the multiplexer to which it provides the data; and **in that** the register (13) associated with a first multiplexer (MUX1) receives the data (DATA(12)) issued from a first differential register (12) of a shift register (16) of which it constitutes a second register, said first register (12) being controlled by said first clock signal (CLK0).

7. The ATM device of claim 6, **characterized in that** said differential registers (12, 13, 14, 15) are respectively controlled by the falling edges of said first clock signal (CLK0), by the rising edges of a first sampling signal (CLK1) of the first multiplexer (MUX1), by the falling edges of a second sampling signal (CLK2) of a second multiplexer (MUX2), and by the falling edges of a third sampling signal (CLK3) of a third multiplexer (MUX3).

8. The serialization device (ATM) of claim 6 or 7, **characterized in that** the frequency of said first clock signal (CLK0) is approximately 77.76 MHz, and wherein the frequency of said clock signal (CLKS) for transmission of the serialized data (DATAS) is approximately 622.08 MHz.

CLKP — 6 — CLK0 — CLKS

2 — 3 — ÷ — CLK1 — CLK2 — CLK3 — CLK4

5 — DATAP — DATAS

1 — MUX1 — MUX2 — MUX3 — 4

Fig 1

CLKP — 6 — 2 — CLK0 — 3 — ÷ — CLKS

CLK1 — CLK2 — CLK3 — CLK4

11 — 5 — DATAP — 12 — 16 — NCK — CK — NCK — CK — NCK — CK — DATAS

13 — MUX1 — 14 — MUX 2 — 15 — MUX3 — 4

Fig 2

CLKP

D0 1 0
D1 1 0
D2 1 0
D3 1 0

DATAP

$\tau e$

CLK0

D0 1 0
D1 1 0
D2 1 0
D3 1 0

DATA(5)

$\tau 6$

$\tau 5$

Fig 3

Fig 4

Fig 5

EP 0 715 415 B1

CLK2

DATA(14) { D01  1 0   τ14   D1   D0

D23  1 0   D3   D2 }

DATA(MUX2)  1 0   τ2   D1   D3   D0   D2

TMAX(4)   τ8

CLKS

DATAS  1 0   τ4   D1   D3   D0   D2

Fig 6

Fig 7

EP 0 715 415 B1